(19) Europäisches Patentamt
European Patent Office
Office européen des brevets

(11) **EP 4 527 976 A2**

(12) **EUROPEAN PATENT APPLICATION**

(43) Date of publication:
**26.03.2025 Bulletin 2025/13**

(21) Application number: **24201410.8**

(22) Date of filing: **19.09.2024**

(51) International Patent Classification (IPC):
***C23C 16/455*** (2006.01)

(52) Cooperative Patent Classification (CPC):
**C23C 16/45523**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **21.09.2023 JP 2023156504**

(71) Applicant: **Kokusai Electric Corporation**
**Tokyo 101-0045 (JP)**

(72) Inventors:
• **ORIHASHI, Yugo**
**Toyama-shi, Toyama, 9392393 (JP)**

• **MORIYA, Atsushi**
**Toyama-shi, Toyama, 9392393 (JP)**
• **MEGAWA, Yasuhiro**
**Toyama-shi, Toyama, 9392393 (JP)**
• **KOSHI, Yasunobu**
**Toyama-shi, Toyama, 9392393 (JP)**
• **MIYAKURA, Takahiro**
**Toyama-shi, Toyama, 9392393 (JP)**

(74) Representative: **Bardehle Pagenberg**
**Partnerschaft mbB**
**Patentanwälte Rechtsanwälte**
**Prinzregentenplatz 7**
**81675 München (DE)**

(54) **SUBSTRATE PROCESSING METHOD, METHOD OF MANUFACTURING SEMICONDUCTOR DEVICE, PROGRAM AND SUBSTRATE PROCESSING APPARATUS**

(57) There is provided a technique that includes (a) supplying a first gas and a second gas to a substrate (200) to form a film, and (b) improving a flatness of a surface of the film.

## FIG. 4

**Description**

CROSS-REFERENCE TO RELATED APPLICATION

This application is based upon and claims the benefit of priority from Japanese Patent Application No. 2023-156504, filed on September 21, 2023, the entire contents of which are incorporated herein by reference.

TECHNICAL FIELD

The present disclosure relates to a substrate processing method, a method of manufacturing a semiconductor device, a program, and a substrate processing apparatus.

BACKGROUND

In the related art, as a process of manufacturing a semiconductor device, a process of forming a film on a substrate is often performed.

SUMMARY

Some embodiments of the present disclosure provide a technique capable of enhancing a flatness of a surface of a film formed on a substrate to improve a surface roughness of the film.
According to one embodiment of the present disclosure, there is provided a technique that includes (a) supplying a first gas and a second gas to a substrate to form a film, and (b) improving a flatness of a surface of the film.

BRIEF DESCRIPTION OF DRAWINGS

The accompanying drawings, which are incorporated in and constitute a part of the specification, illustrate embodiments of the present disclosure.

FIG. 1 is a schematic configuration diagram of a vertical process furnace of a substrate processing apparatus used in one embodiment, in which a process furnace is partially illustrated in a vertical sectional view.
FIG. 2 is a schematic configuration diagram of the vertical process furnace of the substrate processing apparatus used in one embodiment, in which the process furnace is partially illustrated in a sectional view taken along line A-A in FIG. 1.
FIG. 3 is a schematic configuration diagram of a controller of the substrate processing apparatus used in one embodiment, in which a control system of the controller is illustrated in a block diagram.
FIG. 4 is a diagram showing a processing sequence in one embodiment.

DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure embodiments of the various embodiments.

<One Aspect of the Present Disclosure>

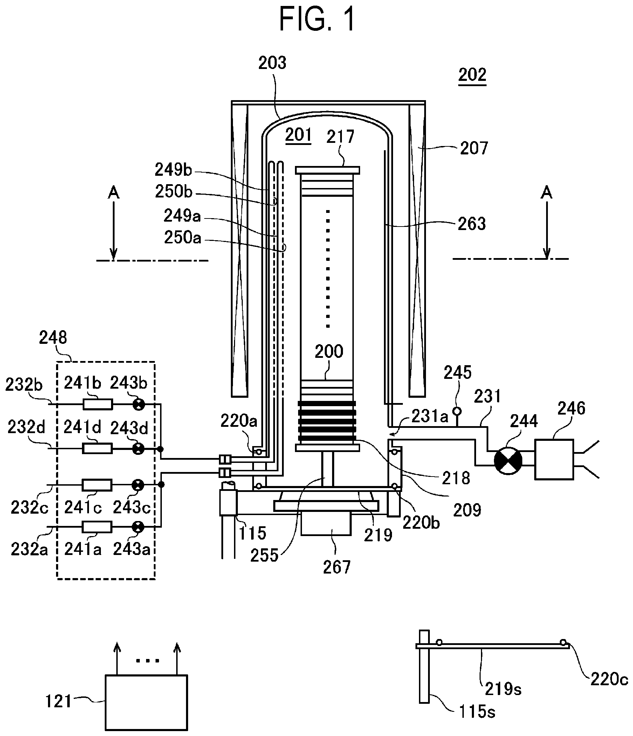

Hereinafter, one embodiment of the present disclosure will be described mainly with reference to FIGS. 1 to 4. In addition, it should be noted that the drawings are schematic, and the relationships between dimensions of respective elements, the ratios of the respective elements, and the like may differ from reality. Also, there may be a case where the relationship of dimensions and the ratios differ from each other between the drawings.

(1) Configuration of Substrate Processing Apparatus

As shown in FIG. 1, a process furnace 202 includes a heater 207 as a temperature adjuster (heater). The heater 207 has a cylindrical shape and is vertically installed by being supported by a holding plate. The heater 207 also functions as an activation mechanism (exciter) that activates (excites) a gas with heat.

Inside the heater 207, a reaction tube 203 is arranged concentrically with the heater 207. The reaction tube 203 is made of a heat-resistant material such as quartz ($SiO_2$) or silicon carbide (SiC), and has a cylindrical shape with a closed upper end and an open lower end. A manifold 209 is arranged below the reaction tube 203 in a concentric relationship with the reaction tube 203. The manifold 209 is made of a metal-containing material such as stainless steel (SUS), and has a cylindrical shape with open upper and lower ends. The upper end of the manifold 209 is engaged with the lower end of the reaction tube 203 and is configured to support the reaction tube 203. An O-ring 220a is provided as a sealing member between the manifold 209 and the reaction tube 203. Just like the heater 207, the reaction tube 203 is installed vertically. A processing container (reaction container) is mainly constituted with the reaction tube 203 and the manifold 209. A process chamber 201 is formed in a cylindrical hollow portion of the processing container. The process chamber 201 is configured to accommodate wafers 200 as substrates. Processing is performed on the wafer 200 inside the process chamber 201.

Inside the process chamber 201, nozzles 249a and 249b as first and second suppliers are installed so as to penetrate a sidewall of the manifold 209, respectively. The nozzles 249a and 249b are also referred to as first and second nozzles, respectively. The nozzles 249a and 249b are made of a heat-resistant material such as quartz or SiC. Gas supply pipes 232a and 232b are connected to the nozzles 249a and 249b, respectively. The nozzles 249a and 249b are installed adjacent to each other.

On the gas supply pipes 232a and 232b, mass flow controllers (MFCs) 241a and 241b, which are flow rate controllers (flow rate controllers), and valves 243a and 243b, which are on-off valves, are provided sequentially from an upstream side of a gas flow. A gas supply pipe 232c is connected to the gas supply pipe 232a on a downstream side of the valve 243a. On the gas supply pipe 232c, an MFC 241c and a valve 243c are provided sequentially from the upstream side of the gas flow. A gas supply pipe 232d is connected to the gas supply pipe 232b on a downstream of the valve 243b. On the gas supply pipe 232d, an MFC 241d and a valve 243d are provided sequentially from the upstream side of the gas flow. The gas supply pipes 232a to 232d are made of a metal material such as stainless steel (SUS) or the like.

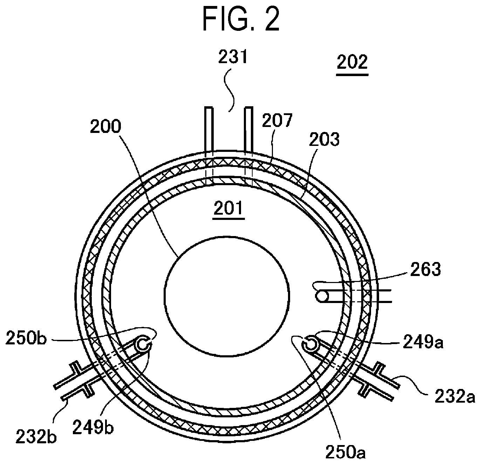

As shown in FIG. 2, the nozzles 249a and 249b are provided in a circular space between an inner wall of the reaction tube 203 and the wafers 200 in a plan view to extend upward from a lower portion to an upper portion of the inner wall of the reaction tube 203 in an arrangement direction of the wafers 200. That is, the nozzles 249a and 249b are provided in a region existing on a lateral side of and horizontally surrounding a wafer arrangement region in which the wafers 200 are arranged, so as to extend along the wafer arrangement region. Gas supply holes 250a and 250b for supplying gases are provided on the side surfaces of the nozzles 249a and 249b, respectively. Each of the gas supply holes 250a and 250b is open toward centers of the wafers 200 in a plan view, and is configured to supply the gas toward the wafers 200. A plurality of gas supply holes 250a and 250b are provided from the lower portion to the upper portion of the reaction tube 203.

A first gas is supplied from the gas supply pipe 232a into the process chamber 201 via the MFC 241a, the valve 243a, and the nozzle 249a. The first gas acts as a raw material gas, which is one of film-forming gases.

A second gas is supplied from the gas supply pipe 232b into the process chamber 201 via the MFC 241b, the valve 243b, and the nozzle 249b. The second gas acts as a dopant gas, which is one of the film-forming gases.

An inert gas is supplied from the gas supply pipes 232c and 232d into the process chamber 201 via the MFCs 241c and 241d, the valves 243c and 243d, the gas supply pipes 232a and 232b, and the nozzles 249a and 249b. The inert gas acts as a purge gas, a carrier gas, a dilution gas, or the like.

A first gas supply system is mainly constituted with the gas supply pipe 232a, the MFC 241a, and the valve 243a. A second gas supply system is mainly constituted with the gas supply pipe 232b, the MFC 241b, and the valve 243b. An inert gas supply system is mainly constituted with the gas supply pipes 232c and 232d, the MFCs 241c and 241d, and the valves 243c and 243d. The nozzles connected to the gas supply pipes constituting the various supply systems mentioned above may be included in the respective supply systems.

One or all of the above-described various supply systems may be configured as an integrated-type supply system 248 in which the valves 243a to 243d, the MFCs 241a to 241d, and the like are integrated. The integrated-type supply system 248 is connected to each of the gas supply pipes 232a to 232d. In addition, the integrated-type supply system 248 is configured such that operations of supplying various materials (various gases) into the gas supply pipes 232a to 232d, that is, the opening/closing operation of the valves 243a to 243d, the flow rate adjustment operation by the MFCs 241a to 241d, and the like, are controlled by a controller 121 which will be described later. The integrated-type supply system 248 may be configured as an integral type or detachable-type integrated unit, and may be attached to and detached from the gas supply pipes 232a to 232d and the like on an integrated unit basis, so that the maintenance, replacement, extension and the like of the integrated-type supply system 248 may be performed on an integrated unit basis.

The exhaust port 231a for exhausting an internal atmosphere of the process chamber 201 is provided below the sidewall of the reaction tube 203. The exhaust port 231a may be provided from a lower portion of the sidewall of the reaction tube 203 to an upper portion thereof, that is, along the wafer arrangement region. An exhaust pipe 231 is connected to the exhaust port 231a. The exhaust pipe 231 is made of a metal material such as SUS or the like. A vacuum pump 246 as a vacuum exhaust device is connected to the exhaust pipe 231 via a pressure sensor 245, which is a pressure detector (pressure detection part) for detecting the internal pressure of the process chamber 201, and an auto pressure controller (APC) valve 244, which is a pressure regulator (pressure adjustment part). The APC valve 244 is configured to perform or stop a vacuum exhaust operation for the interior of the process chamber 201 by opening/closing the valve while the vacuum pump 246 is actuated. Further, the APC valve 244 is configured to adjust the internal pressure of the process chamber 201 by adjusting an opening degree of the valve based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219, which serves as a furnace opening cover configured to hermetically seal a lower end opening of the manifold 209, is provided under the manifold 209. The seal cap 219 is made of, for example, a metal material such as SUS, and is formed in a disc shape. An O-ring 220b, which is a seal member making contact with the lower end of the manifold 209, is provided on an upper surface of the seal cap 219. A rotation mechanism 267 configured to rotate a boat 217 (to be described later) is installed under the seal cap 219. A rotary shaft 255 of the rotation mechanism 267 is made of, for example, a metal material such as SUS, and is connected to the boat 217 via the seal cap 219. The rotation mechanism 267 is configured to rotate the wafers 200 by rotating the boat 217. The seal cap 219 is configured to be vertically moved up and down by a boat elevator 115 which is an elevating mechanism installed outside the reaction tube 203. The boat elevator 115 is configured as a transfer system (transfer mechanism) which loads/unloads (transfers) the wafers 200 into/out of the process chamber 201 by moving the seal cap 219 up and down.

A shutter 219s, which serves as a furnace opening cover configured to hermetically seal a lower end opening of the manifold 209 in a state where the seal cap 219 is lowered and the boat 217 is unloaded from the process chamber 201, is provided under the manifold 209. The shutter 219s is made of, for example, a metal material such as SUS, and is formed in a disc shape. An O-ring 220c, which is a seal member making contact with the lower end of the manifold 209, is provided on an upper surface of the shutter 219s. The opening/closing operation (such as elevation operation, rotation operation, or the like) of the shutter 219s is controlled by a shutter opening/closing mechanism 115s.

The boat 217 serving as a substrate support is configured to support a plurality of (for example, 25 to 200) wafers in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. Heat insulating plates 218 made of, for example, a heat resistant material such as quartz or SiC, are installed below the boat 217 in multiple stages.

A temperature sensor 263 serving as a temperature detector is installed inside the reaction tube 203. Based on temperature information detected by the temperature sensor 263, a state of supplying electric power to the heater 207 is adjusted such that an interior of the process chamber 201 has a desired temperature distribution. The temperature sensor 263 is provided along the inner wall of the reaction tube 203.

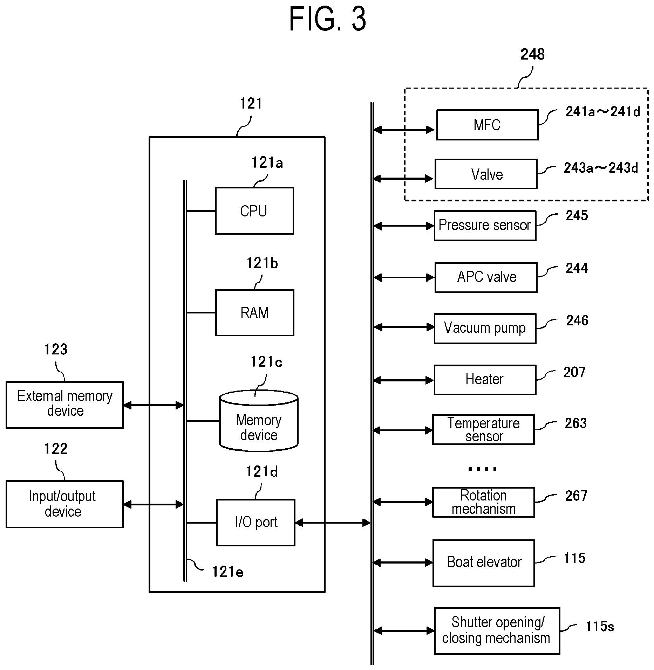

As shown in FIG. 3, a controller 121, which is a control part (control means), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 constituted with, e.g., a touch panel or the like, is connected to the controller 121. Further, an external memory 123 may be connected to the controller 121. Further, the substrate processing apparatus may be configured to include one controller or a plurality of controllers. That is, the control for performing the processing sequence described later may be performed using one controller or the plurality of controllers. The plurality of controllers may be configured as control systems connected to each other via a wired or wireless communication network. The control for performing the processing sequence described later may be performed by all the control systems. When the term "controller" is used in this specification, it may include one controller, a plurality of controllers, or a control system configured by the plurality of controllers.

The memory 121c is configured by, for example, a flash memory, a hard disk drive (HDD), a solid state drive (SSD), or the like. A control program for controlling operations of a substrate processing apparatus, a process recipe in which sequences and conditions of substrate processing to be described later are written, or the like, are readably recorded and stored in the memory 121c. The process recipe functions as a program that causes, by the controller 121, the substrate processing apparatus to execute each sequence in the substrate processing (to be described later) to obtain an expected result. Hereinafter, the process recipe and the control program may be generally and simply referred to as a "program". Further, the process recipe may be simply referred to as a "recipe". When the term "program" is used herein, it may indicate a case of including the recipe alone, a case of including the control program alone, or a case of including both the recipe and the control program. The RAM 121b is configured as a memory area in which programs or data read by the CPU 121a are temporarily stored.

The I/O port 121d is connected to the MFCs 241a to 241e, the valves 243a to 243d, the pressure sensor 245, the APC valve 244, the vacuum pump 246, the temperature sensor 263, the heater 207, the rotation mechanism 267, the boat elevator 115, the shutter opening/closing mechanism 115s, and the like.

The CPU 121a is configured to read and execute the control program from the memory 121c. The CPU 121a is also configured to read the recipe from the memory 121c according to an operation command input by the input/output device 122. The CPU 121a is configured to control the flow rate adjusting operation of various kinds of materials (gases) by the MFCs 241a to 241e, the opening/closing operation of the valves 243a to 243d, the opening/closing operation of the APC valve 244, the pressure adjusting operation performed by the APC valve 244 based on the pressure sensor 245, the actuating and stopping operation of the vacuum pump 246, the temperature adjusting operation performed by the heater 207 based on the temperature sensor 263, the operation of rotating the boat 217 with the rotation mechanism 267 and adjusting the rotation speed of the boat 217, the operation of moving the boat 217 up and down by the boat elevator 115, the opening/closing operation of the shutter 219s by the shutter opening/closing mechanism 115s, and the like, according to contents of the read recipe.

The controller 121 may be configured by installing, on the computer, the aforementioned program recorded and stored in the external memory 123. Examples of the external memory 123 may include a magnetic disk such as a HDD, an optical disc such as a CD, a magneto-optical disc such as a MO, a semiconductor memory such as a USB memory or a SSD, and the like. The memory 121c or the external memory 123 is configured as a non-transitory computer-readable recording medium. Hereinafter, the memory 121c and the external memory 123 may be generally and simply referred to as a "recording medium". When the term "recording medium" is used herein, it may indicate a case of including the memory 121c alone, a case of including the external memory 123 alone, or a case of including both the memory 121c and the external memory 123. Further, the program may be provided to the computer using communication means such as the Internet or a dedicated line, instead of using the external memory 123.

(2) Substrate Processing Process

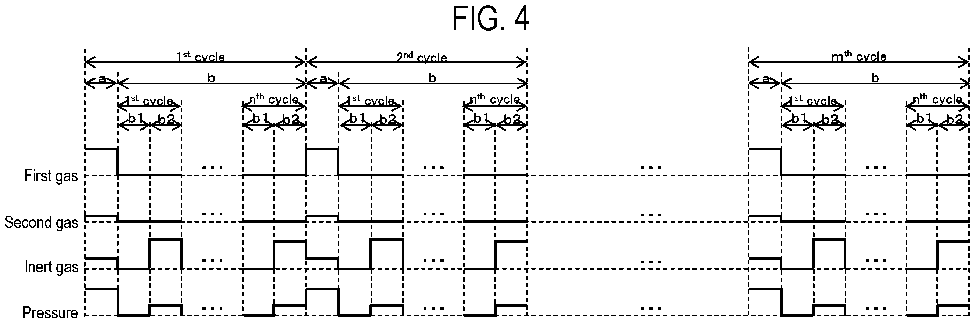

As a process of manufacturing a semiconductor device using the above-described substrate processing apparatus, an example of a method of processing a substrate, that is, a processing sequence for forming a film on the wafer 200 as a substrate, will be described mainly with reference to FIG. 4. In the following description, the operations of the respective parts constituting the substrate processing apparatus are controlled by the controller 121.

The processing sequence according to the present embodiment includes:

(a) Step A of supplying a first gas and a second gas to the wafer 200 to form the film; and
(b) Step B of improving a flatness of a surface of the film.

In the following, an example will be described in which a cycle of non-simultaneously executing Step A and Step B is performed a predetermined number of times (m times, where m is an integer of 1 or 2 or more).

Further, in the following, an example will be described in which, in Step B, a cycle includes Step B1 of removing a gas from a space in which the wafer 200 exists and subsequently, Step B2 of supplying an inert gas is performed a predetermined number of times (n times, where n is an integer of 1 or 2 or more).

Further, in the following, an example will be described in which a predetermined seed film is formed in advance on the surface of the wafer 200.

In FIG. 4, a indicates Step A, b indicates Step B, b1 indicates Step B1, and b2 indicates Step B2.

In the present disclosure, for the sake of convenience, the above-described processing sequence may be denoted as follows. The same denotation may be used in modifications and other embodiments to be described later.

$$\{(\text{first gas} + \text{second gas}) \rightarrow (\text{gas removal} \rightarrow \text{inert gas}) \times n\} \times m$$

When the term "wafer" is used in the present disclosure, it may refer to "a wafer itself" or "a wafer and a stacked body of certain layers or films formed on a surface of the wafer." When the phrase "a surface of a wafer" is used in the present disclosure, it may refer to "a surface of a wafer itself" or "a surface of a certain layer formed on a wafer." When the expression "a certain layer is formed on a wafer" is used in the present disclosure, it may mean that "a certain layer is formed directly on a surface of a wafer itself" or that "a certain layer is formed on a layer formed on a wafer." When the term "substrate" is used in the present disclosure, it may be synonymous with the term "wafer."

The term "layer" used herein includes at least one selected from the group of a continuous layer and a discontinuous layer.

As used herein, the term "layer" includes at least one of a continuous layer and a discontinuous layer.

(Wafer Charging and Boat Loading)

After the boat 217 is charged with the plurality of wafers 200 (wafer charging), the shutter 219s is moved by the shutter opening/closing mechanism 115s and the lower end opening of the manifold 209 is open. Thereafter, as shown in FIG. 1, the boat 217 that supports the plurality of wafers 200 is lifted up by the boat elevator 115 to be loaded into the process chamber 201 (boat loading). In this state, the seal cap 219 seals the lower end of the manifold 209 through the O-ring 220b. Thus, the wafers 200 are prepared (provided) inside the process chamber 201.

(Pressure Adjustment and Temperature Adjustment)

After the boat loading is completed, the interior of the process chamber 201, that is, a space where the wafers 200 are placed, is vacuum-exhausted (decompression-exhausted) by the vacuum pump 246 to reach a desired pressure (degree of vacuum). At this time, the internal pressure of the process chamber 201 is measured by the pressure sensor 245, and the APC valve 244 is feedback-controlled based on the measured pressure information. Further, the wafers 200 inside the process chamber 201 are heated by the heater 207 so as to have a desired temperature. At this time, the state of supplying electric power to the heater 207 is feedback-controlled based on the temperature information detected by the temperature sensor 263 so that the interior of the process chamber 201 has a desired temperature distribution. Further, the rotation of the wafers 200 by the rotation mechanism 267 is started. The exhaust of the interior of the process chamber 201 and the heating and rotation of the wafers 200 are continuously performed at least until the processing on the wafers 200 is completed.

(Film-forming Step: Step A)

In this step, a first gas and a second gas are supplied to the wafer 200 in the process chamber 201.

Specifically, the valves 243a and 243b are open to allow the first gas and the second gas to flow into the gas supply pipes 232a and 232b, respectively. The flow rates of the first gas and the second gas are adjusted by the MFCs 241a and 241b, respectively. The first gas and the second gas are supplied into the process chamber 201 via the nozzles 249a and 249b, mixed in the process chamber 201, and exhausted via the exhaust port 231a. At this time, the first gas and the second gas are supplied to the wafers 200 from the lateral side of the wafers 200 (supply of first gas + second gas). At this time, the valves 243c and 243d may be open to supply an inert gas into the process chamber 201 via the nozzles 249a and 249b.

Processing conditions when supplying the first gas and the second gas in this step are exemplified as follows.

Processing temperature: 300 to 500 degrees C, preferably 350 to 450 degrees C
Processing pressure: 100 to 1,000 Pa, preferably 200 to 700 Pa
Supply flow rate of first gas: 0.5 to 3 slm, preferably 0.8 to 2 slm
Supply flow rate of second gas: 0.001 to 0.02 slm, preferably 0.005 to 0.01 slm
Supply flow rate of inert gas (per gas supply pipe): 0 to 20 slm
Supply time of each gas: 1 to 300 minutes

The processing conditions shown here are conditions under which the first gas and the second gas undergo gas-phase decomposition (thermal decomposition), that is, conditions under which a CVD reaction occurs, when each of the first gas and the second gas presents independently inside the process chamber 201. In other words, the processing conditions shown here are conditions under which the adsorption (deposition) of the first gas and the second gas on the surface of the wafer 200 is not self-limited, that is, conditions under which the adsorption of the first gas and the second gas on the wafer 200 is non-self-limited.

In this specification, the notation of a numerical range such as "300 to 500 degrees C" means that the lower limit value and the upper limit value are included in the range. Therefore, for example, "300 to 500 degrees C" means "300 degrees C or higher and 500 degrees C or lower." The same applies to other numerical ranges. In this specification, the processing temperature means the temperature of the wafer 200 or the internal temperature of the process chamber 201, and the processing pressure means the internal pressure of the process chamber 201, that is, an internal pressure of the space in which the wafers 200 exist. Further, the processing time means the time during which a process is continued. Further, the gas supply flow rate of 0slm means a case where no substance (gas) is supplied. These apply equally to the following description.

By supplying the first gas and the second gas to the wafer 200 under the above-mentioned processing conditions, each of the first gas and the second gas is decomposed in a gas phase, so that at least a part of the molecular structure of the molecules constituting the first gas and at least a part of the molecular structure of the molecules constituting the second gas may be adsorbed (deposited) on the surface of the wafer 200, that is, on the seed film formed on the wafer 200, thereby forming a film.

As the first gas, a gas containing a compound represented by a formula $M1Rx$ may be used. Herein, M1 is a first element, R is a group (also called a residue, a substituent, or a ligand), and x is an integer of 1 or more. The first gas may be a gas containing the first element and one or more Rs bonded to the first element in one molecule. R is selected from the group consisting of a hydrogen element, an alkyl group, a halogen element, and the like.

As the first gas, for example, a silicon hydride gas containing silicon (Si) as the first element and hydrogen (H) as R, such as a monosilane ($SiH_4$) gas, a disilane ($Si_2H_6$) gas, a trisilane ($Si_3H_8$) gas, a tetrasilane ($Si_4H_{10}$) gas, a pentasilane ($Si_5H1_2$) gas, a hexasilane ($Si_6H_{14}$) gas, or the like, may be used. As the first gas, one or more of these gases may be used.

As the first gas, for example, a halosilane gas containing Si as the first element and halogen as R may be used. The halogen includes chlorine (Cl), fluorine (F), bromine (Br), iodine (I), or the like. As the first gas, for example, a chlorosilane gas such as a monochlorosilane ($SiH_3Cl$) gas, a dichlorosilane ($SiH_2Cl_2$) gas, a trichlorosilane ($SiHC1_3$) gas, a tetrachlorosilane ($SiCl_4$) gas, a hexachlorodisilane gas ($Si_2Cl_6$) gas, an octachlorotrisilane ($Si_3Cl_8$) gas, or the like may be used. As the first gas, one or more of these gases may be used.

As the first gas, in addition to the chlorosilane gas, for example, a fluorosilane gas such as a tetrafluorosilane ($SiF_4$) gas or a difluorosilane ($SiH_2F_2$) gas, a bromosilane gas such as a tetrabromosilane ($SiBr_4$) gas or a dibromosilane ($SiH_2Br_2$) gas, or an iodosilane gas such as a tetraiodosilane ($SiI_4$) gas or a diiodosilane ($SiH_2I_2$) gas, may be used. One or more of these gases may be used as the first gas.

As the first gas, in addition to these gases, for example, a gas containing Si as the first element and an alkyl group as R, that is, an alkylsilane-based gas, may be used. The alkyl group is a generic term for the remaining atomic group obtained by removing one H atom from an alkane (a chain saturated hydrocarbon represented by a general formula $C_nH_{2n+2}$), and is a functional group represented by a general formula $C_nH_{2n+1}$. The alkyl group includes a methyl group, an ethyl group, a propyl group, a butyl group, and the like. The first gas may be, for example, an alkylsilane-based gas such as a monomethylsilane ($SiH_3CH_3$) gas, a dimethylsilane ($SiH_2(CH_3)_2$) gas, a trimethylsilane ($SiH(CH_3)_3$) gas, a hexamethyldisilane ($(CH_3)_3Si_2(CH_3)_3$) gas, a monoethylsilane ($SiH_3C_2H_5$) gas, a triethylsilane ($SiH(C_2H_5)_3$) gas, a diethylsilane ($SiH_2(C_2H_5)_2$) gas, or the like. As the first gas, one or more of these gases may be used.

The second gas may be a gas containing a compound represented by a formula M2Ry, where M2 is a second element, R is a group (also called a residue, a substituent, or a ligand), and y is an integer of 1 or more. The second gas may be a gas containing a second element and one or more Rs bonded to the second element in one molecule. R is selected from the group consisting of a hydrogen element, an alkyl group, a halogen element, and the like.

As the second gas, for example, a phosphine-based gas such as a phosphine ($PH_3$) gas, a diphosphine ($P_2H_6$) gas or the like containing phosphorus (P), which is a Group 15 element, as the second element and H as R, may be used. One or more of these gases may be used as the second gas.

As the second gas, for example, a halogenated phosphorus gas such as a phosphorus trichloride ($PCl_3$) gas or the like containing P, which is a Group 15 element, as the second element and halogen as R, may be used.

As the inert gas, for example, a nitrogen ($N_2$) gas, or a noble gas such as an argon (Ar) gas, a helium (He) gas, a neon (Ne) gas, a xenon (Xe) gas or the like, may be used. One or more of these gases may be used as the inert gas. This point also applies to each step described below.

By supplying the first gas containing the first element and the second gas containing the second element to the wafer 200 under the above-mentioned conditions, a film containing the first element and the second element, specifically, a first-element-containing film doped (added) with the second element), may be formed on the surface of the wafer 200.

After the film is formed on the surface of the wafer 200, the valves 243a to 243d are closed to stop the supply of the first gas, the second gas, and the inert gas into the process chamber 201. Subsequently, the process chamber 201 is evacuated to remove the gas remaining in the process chamber 201 (in a purging operation). At this time, the valves 243c and 243d are open to supply an inert gas into the process chamber 201. The inert gas acts as a purge gas.

(Planarization Operation: Step B)

Then, the following steps B 1 and B2 are executed in sequence.

[Step B1]

In this step, while the wafer 200 having the film formed on the surface thereof is accommodated in the process chamber 201, the process chamber 201 is evacuated to reduce the internal pressure of the process chamber 201 to a predetermined pressure.

Specifically, while the APC valve 244 is kept at a maximum valve opening degree (fully open), the interior of the process chamber 201 is evacuated by the vacuum pump 246. At this time, the valves 243c and 243d remain closed, and no inert gas is supplied to the process chamber 201. The expression "fully open" does not necessarily mean that the valve opening degree is 100%, and an error of -10% may be acceptable. The error is preferably -5%. The valve opening degree including such an error is also called "approximately fully open" or "substantially fully open."

Processing conditions in this step are exemplified as follows.

Processing temperature: 300 to 500 degrees C, preferably 350 to 450 degrees C

Processing pressure: 0.1 to 10 Pa, preferably 0.1 to 5 Pa
Evacuation time: 1 to 100 minutes

The processing pressure in this step is lower than the processing pressure in Step A.

By evacuating the interior of the process chamber 201, the first gas, the second gas, the reaction products, the inert gas, and the like remaining in the process chamber 201 are removed from the process chamber 201 to clean the interior of the process chamber 201, that is, at least the surface of the wafer 200.

After the evacuation of the process chamber 201 is completed, the valve opening degree of the APC valve 244 is adjusted (reduced) to pressurize the interior of the process chamber 201 to a predetermined pressure. When the internal pressure of the process chamber 201 reaches the predetermined pressure, the next Step B2 is executed.

[Step B2]

In this step, the inert gas is supplied to the wafer 200 in the process chamber 201.

Specifically, the valves 243c and 243d are open to allow the inert gas to flow into the gas supply pipes 232c and 232d. The flow rate of the inert gas is adjusted by the MFCs 241c and 241d. The inert gas is supplied into the process chamber 201 via the nozzles 249a and 249b, and is exhausted from the exhaust port 231a. At this time, the inert gas is supplied to the wafer 200 from the lateral side of the wafer 200 (in an inert gas supply operation).

Processing conditions when supplying the inert gas in this step are exemplified as follows.

Processing temperature: 300 to 500 degrees C, preferably 350 to 450 degrees C
Processing pressure: 1 to 100 Pa, preferably 10 to 30 Pa
Supply flow rate of inert gas (per gas supply pipe): 2 to 10 slm, preferably 3 to 5 slm
Supply time of inert gas: 1 to 100 minutes

The processing pressure in this step is preferably lower than the processing pressure in Step A.

By supplying the inert gas to the wafer 200 under the above-mentioned processing conditions, the interior of the process chamber 201 is purged, the first gas, the second gas, the reaction by-products, and the like remaining in the process chamber 201 are removed from the interior of the process chamber 201, and an internal atmosphere of the process chamber 201 is replaced with the inert gas.

After the purging of the interior of the process chamber 201 is completed, the valves 243c and 243d are closed to stop the supply of the inert gas into the process chamber 201.

[Performing Cycle Predetermined Number of Times]

A cycle of performing the above-described Steps A and B in the named order asynchronously, that is, without synchronization, is performed m times (where m is an integer of 1 or 2 or more), so that a film having a desired thickness may be formed on the surface of the wafer 200. It is preferable to repeat the above-mentioned cycle multiple times. That is, it is preferable that the thickness of the film formed per cycle is set to be smaller than a desired film thickness, and the above-mentioned cycle is repeated multiple times until the film formed by stacking the film formed in each cycle has the desired film thickness. Further, in Step B performed after performing Step A, a cycle (hereinafter sometimes referred to as a planarization cycle) of performing steps B 1 and B2 in the named order asynchronously, that is, without synchronization, is performed n times (where n is an integer of 1 or 2 or more). This may improve the flatness of the surface of the film formed on the wafer 200. Details of the flatness of the surface of the film will be described later.

(Purging and Returning to Atmospheric Pressure)

After the film-forming processing is completed, an inert gas acting as a purge gas is supplied into the process chamber 201 from each of the nozzles 249a and 249b and is exhausted from the exhaust port 231a. Thus, the interior of the process chamber 201 is purged, and a gas, reaction by-products, and the like remaining in the process chamber 201 are removed from the process chamber 201 (in a purging operation). After that, the internal atmosphere of the process chamber 201 is substituted with an inert gas (inert gas substitution) and the internal pressure of the process chamber 201 is returned to the atmospheric pressure (returning to atmospheric pressure).

(Boat Unloading and Wafer Discharging)

After that, the seal cap 219 is moved down by the boat elevator 115 to open the lower end of the manifold 209. Then, the processed wafers 200 supported by the boat 217 are unloaded from the lower end of the manifold 209 to the outside of the reaction tube 203 (boat unloading). After the boat unloading, the shutter 219s is moved and the lower end opening of the manifold 209 is sealed by the shutter 219s via the O-ring 220c. The processed wafers 200 are unloaded from the reaction tube 203 and are then discharged from the boat 217 (wafer discharging).

(3) Effects of the Present Embodiment

According to the present embodiment, one or more effects set forth below may be achieved.

(a) In Step B, by improving the flatness of the surface of the film formed on the wafer 200, it is possible to improve the surface roughness of the film. This will be explained below. As used herein, the expression "surface roughness" means a height difference of the film in the wafer plane (synonymous with surface roughness). The smaller the surface roughness, the smoother the surface. In other words, improving the surface roughness means reducing the height difference of the film and improving the smoothness of the surface.

In the present disclosure, a state in which the number of Rs is less than M1Rx is also called M1Ra. "a" is an integer of 1 or more, and has a relationship of a<x. Further, a state in which the number of Rs is less than M2Ry is also called M2Rb. "b" is an integer of 1 or more, and has a relationship of b<y. In the following example, a case where a material in which M1 is Si and R is H, and a material in which M2 is P and R is H are used will be described. In this case, M1Rx is $SiH_4$, and MIRa includes at least one selected from the group consisting of $SiH_3$, $SiH_2$, SiH and the like. M2Ry is $PH_3$, and M2Rb includes at least one selected from the group consisting of $PH_2$ and PH.

As described above, Step A is performed under the conditions in which the first gas and the second gas are thermally decomposed. As a result, in Step A, at least a part of the molecular structure of the molecules constituting the first gas and at least a part of the molecular structure of the molecules constituting the second gas are adsorbed (deposited) on the wafer 200 to form a film. Specifically, for example, when an M1Rx gas is used as the first gas and an M2Ry gas is used as the second gas, the molecules constituting the first gas (M1Rx) and the molecules constituting the second gas (M2Ry) are physically adsorbed on the wafer 200, or a part of the molecular structure of the molecules constituting the first gas (M1Ra) and a part of the molecular structure of the molecules constituting the second gas (M2Rb) are physically adsorbed or chemically adsorbed on the wafer 200, or these are deposited to form a film containing the first element and the second element. Since M1Ra, M2Rb, and the like are physically adsorbed or chemically adsorbed on the outermost surface of the film formed in this manner, the flatness of the surface of the film is likely to deteriorate, which may increase the surface roughness.

(b) According to the present embodiment, in Step B, at least some of the molecules (M1Rx, M1Ra, M2Ry, and M2Rb) adsorbed on the outermost surface of the film formed on the wafer 200 are removed. Specifically, in Step B2, the inert gas is supplied to the wafer 200, so that the molecules of the inert gas collide with the molecules (M1Rx, M1Ra, M2Ry, and M2Rb) adsorbed on the surface of the film, thereby desorbing the molecules from the surface of the film. This may improve the flatness of the surface of the film and may improve the surface roughness of the film. The expression " at least some of the molecules (M1Rx, M1Ra, M2Ry, and M2Rb) adsorbed on the outermost surface of the film are removed" in Step B means reducing the number of atoms (the first element and the second element) constituting the film, or reducing the number of molecules adsorbed on the surface of the film. In this specification, the molecules adsorbed on the outermost surface of the film or the molecules adsorbed on the surface of the film include the molecules constituting the first gas (M1Rx), the molecules constituting the second gas (M2Ry), a part of the molecular structure of the molecules constituting the first gas (M1Ra), and a part of the molecular structure of the molecules constituting the second gas (M2Rb).

(c) According to the present embodiment, at least the physically adsorbed molecules among the molecules physically adsorbed and chemically adsorbed on the surface of the film are removed in Step B. Specifically, in Step B2, the inert gas is supplied to the wafer 200 so that the molecules of the inert gas collide with the molecules (M1Rx, M1Ra, M2Ry, and M2Rb) physically adsorbed on the surface of the film and the molecules (M1Ra, and M2Rb) chemically adsorbed on the surface of the film, thereby desorbing at least the physically adsorbed molecules from the surface of the film. In this way, the physically adsorbed molecules, which account for the overwhelming majority of the molecules physically adsorbed and chemically adsorbed on the surface of the film, are desorbed from the surface of the film, which makes it possible to effectively enhance the flatness of the surface of the film and effectively improve the surface roughness of the film. In addition, by desorbing the physically adsorbed molecules, which have a weaker adsorption force (bonding force) to the surface of the wafer 200 among the molecules physically adsorbed and chemically adsorbed on the surface of the film, from the surface of the film, the flatness of the surface of the film may be effectively enhanced and the surface roughness of the film may be effectively improved. In this specification, the term "physical adsorbed molecules" includes the molecules constituting the first gas (M1Rx), the molecules constituting the second gas (M2Ry), a part of the molecular structure of the molecules constituting the first gas (M1Ra), and a part of the molecular structure of the molecules constituting the second gas (M2Rb). Further, in this specification, the term "chemically adsorbed molecules" refers to a part of the molecular structure of the molecules constituting the first gas (M1Ra) and a part of the molecular structure of the molecules constituting the second gas (M2Rb).

(d) In the present embodiment, in Step B, some of the molecules chemically adsorbed on the surface of the film are removed. Specifically, in Step B2, the inert gas is supplied to the wafer 200, so that the molecules of the inert gas collide with the molecules (M1Rx, M1Ra, M2Ry, and M2Rb) adsorbed on the surface of the film, thereby desorbing some of the molecules (M1Ra, and M2Rb) chemically adsorbed on the surface of the film from the surface of the film. In this specification, the expression "the molecules chemically adsorbed on the surface of the film" include not only molecules completely chemically adsorbed on the surface of the film, but also molecules being chemically adsorbed on the surface. In this specification, the expression "some of the molecules" does not refer to molecules that are completely chemically adsorbed on the surface of the film, that is, molecules that are firmly adsorbed on the surface of the film, but refers to molecules being chemically adsorbed on the surface (molecules that are not completely chemically adsorbed on the surface), that is, molecules that have a weak adsorption (bonding) force to the surface of the film. By desorbing the molecules, which are being chemically adsorbed and are capable of being desorbed, from the surface of the film in this way, the flatness of the surface of the film may be effectively enhanced, and the surface roughness of the film may be effectively improved.

(e) Step B includes Step B 1 of removing a gas from the interior of the process chamber 201, and subsequently, Step B2 of supplying an inert gas. As described above, in Step B2, the inert gas is supplied to the wafer 200 in the process chamber 201, so that the molecules of the inert gas collide with the molecules (M1Ra, M2Rb, and the like) adsorbed on the surface of the film, thereby desorbing the molecules from the surface of the film. In Step B in the present embodiment, Step B 1 is performed before the start of Step B2, and the first gas, the second gas, and the like remaining in the process chamber 201 are removed from the interior of the process chamber 201, thereby cleaning the interior of the process chamber 201 and at least the surface of the wafer 200 before the start of Step B2. In this specification, the expression "cleaning the interior of the process chamber 201 and at least the surface of the wafer 200" means reducing the number of molecules (M1Ra, M2Rb, and the like) present in the process chamber 201 and on at least the surface of the wafer 200. This may improve the probability that the molecules of the inert gas collide with the molecules (M1Ra, M2Rb, and) adsorbed on the surface of the film in Step B2. As a result, the molecules (M1Ra, M2Rb, and the like) adsorbed on the surface of the film may be easily desorbed from the surface of the film. In addition, by improving the cleanliness of the interior of in the process chamber 201 in Step B1, it becomes possible to suppress the molecules (M1Ra, M2Rb, and the like) desorbed from the surface of the film from being re-adsorbed on the surface of the wafer 200 in Step B2. As a result, the flatness of the surface of the film may be effectively enhanced, and the surface roughness of the film may be effectively improved.

(f) The processing pressure in each of steps B1 and B2 of Step B is lower than the processing pressure in Step A. As a result, in Step B1, the interior of the process chamber 201 may be effectively cleaned, and in Step B2, the molecules (M1Ra, M2Rb, and the like) desorbed from the surface of the film may be effectively suppressed from being re-adsorbed onto the surface of the wafer 200.

(g) In Step B1, the APC valve 244 is fully open to effectively remove the gas remaining in the process chamber 201 and to purify the interior of the process chamber 201. This may improve the probability that the molecules of the inert gas supplied in Step B2 collide with the molecules (M1Ra, M2Rb, and the like) adsorbed on the surface of the film, and may facilitate the desorption of these molecules (M1Ra, M2Rb, and the like). In addition, it is possible to suppress the re-adsorption of M1Ra, M2Rb, and the like desorbed from the surface of the film in Step B2, onto the surface of the wafer 200.

(h) In Step B, the valve opening degree of the APC valve 244 during Step B2 is set to be smaller than the valve opening degree of the APC valve 244 before Step B2 is performed. This may improve the probability that the molecules of the inert gas supplied in Step B2 collide with the molecules (M1Ra, M2Rb, and the like) adsorbed on the surface of the film.

(i) In Step B, the planarization cycle including steps B1 and B2 is performed n times (where n is an integer of 1 or 2 or more), particularly multiple times. This makes it possible to effectively improve the flatness of the surface of the film and effectively enhance the roughness of the surface of the film.

(j) In Step A, two different types of gases, that is, the first gas and the second gas, are simultaneously supplied to the wafer 200, which may easily cause excessive gas reaction and may deteriorate the flatness of the surface of the film. However, according to the present embodiment, the deterioration of the flatness of the surface of the film may be suppressed.

<Other Embodiments of the Present Disclosure>

One embodiment of the present disclosure has been specifically described above. However, the present disclosure is not limited to the above-described embodiment, and various modifications may be made without departing from the present disclosure.

For example, in the above-described embodiment, the case where the first element contained in the first gas is Si has been described as an example. However, the present disclosure is not limited to such an embodiment. For example, the first element may be Ge (germanium). In this case, the first gas may be, for example, a germanium hydride gas such as

a germane (GeH$_4$) gas, a digermane (Ge$_2$H$_6$) gas, a trigermane (Ge$_3$H$_8$) gas, a tetragermane (Ge$_4$H$_{10}$) gas, a pentagermane (Ge$_5$H$_{12}$) gas, a hexagermane (Ge$_6$H$_{14}$) gas or the like. Even in this embodiment, the same effects as those of the above-described embodiment may be obtained.

For example, in the above-described embodiment, the case where the second element contained in the second gas is P, which is a group 15 element, has been described as an example. However, the present disclosure is not limited to such an embodiment. For example, the second element may be arsenic (As), which is a group 15 element, boron (B), Al (aluminum), gallium (Ga), or In (indium), which are group 13 elements. In this case, for example, an arsine (AsH$_3$) gas, a monoborane (BH$_3$) gas, a diborane (B$_2$H$_6$) gas, a triborane (B$_3$H$_8$) gas, a tetraborane (B$_4$H$_{10}$) gas, a boron trichloride (BCl$_3$) gas, a diboron tetrachloride (B$_2$Cl$_4$) gas, an aluminum chloride (AlCl$_3$) gas, a gallium chloride (GaCl$_3$) gas, or an indium chloride (InCl$_3$) gas may be used as the second gas. One or more of these gases may be used as the second gas. Even in this embodiment, the same effects as those of the above-described embodiment may be obtained.

Although not specifically described in the above-described embodiment, a wafer 200 having a recess such as a trench, groove, or hole as a three-dimensional structure formed on the surface thereof may be used. In this embodiment as well, the same effects as those of the above-described embodiment may be obtained. A film formed in a recess tends to easily cause voids and seams during filling. According to this embodiment, it is possible to prevent the occurrence of voids and seams during filling.

In the above-described embodiment, the case where the supply period of the first gas and the supply period of the second gas wholly overlap with each other in Step A, that is, the case where the first gas and the second gas are supplied simultaneously, has been described as an example. However, the present disclosure is not limited to such an embodiment. For example, in Step A, the first gas and the second gas may be supplied so that the supply period of the first gas and the supply period of the second gas overlap at least partially with each other. In this embodiment as well, the same effects as those of the above-described embodiment may be obtained. The supply period of the first gas and the supply period of the second gas may overlap at least partially with each other according to the following supply patterns. The following supply patterns are performed in Step A. As used herein, "+" means that there is a period in which the gases described before and after "+" are supplied simultaneously, and "→" means that the gases are supplied in order and not simultaneously. When the same gas is described before and after "→", it means that the gas is continuously supplied.

(1) First gas + second gas
(2) First gas + second gas → first gas
(3) First gas → first gas + second gas
(4) First gas → first gas + second gas → first gas
(5) First gas → first gas + second gas → second gas

In the above-described embodiment, the case where in Step B, Step B 1 of removing the gas in the process chamber 201 is performed, and subsequently, Step B2 of supplying the inert gas is performed, has been described. However, the present disclosure is not limited to such an embodiment. For example, in Step B, Step B2 of supplying the inert gas may be performed first, and subsequently, Step B1 of removing the gas in the process chamber 201 may be performed. In this embodiment as well, the same effects as those of the above-described embodiment may be obtained.

Although not specifically described in the above-described embodiment, when a cycle including Steps A and B is performed a predetermined number of times, it is preferable that the thickness of a film formed per cycle is set to a thickness of one atomic layer (1 to 2 Å), a thickness of two atomic layers, preferably a thickness of five atomic layers, and more preferably a thickness of more than several atomic layers, and the above-mentioned cycle is repeated 10 to 150 times until a final thickness of 100 to 150 Å is obtained. In this embodiment as well, the same effects as those of the above-described embodiment may be obtained. Further, according to this embodiment, in Step B2, the molecules (SiH$_2$, PH$_2$, and the like.) adsorbed on the surface of the film may be more efficiently desorbed from the surface of the film.

Although not specifically described in the above-described embodiment, when a cycle performing Steps A and B asynchronously is performed m times (where m is an integer of 1 or 2 or more), it is preferable to change the processing conditions in Step B according to the thickness of the film formed per cycle. This is because, when the thickness of the film formed per cycle is large (thick), the flatness of the surface of the film tends to deteriorate, and when the thickness of the film formed per cycle is small (thin), the flatness of the surface of the film is less likely to deteriorate. For this reason, when the thickness T1 of the film formed per cycle is smaller than the thickness T2 of the film formed per cycle, it is preferable to shorten the execution time of Step B per cycle, reduce the processing pressure in Step B, or reduce the supply flow rate of the inert gas supplied in Step B1, as compared with the case where the thickness of the film is T2. In this embodiment as well, the same effects as those of the above-described embodiment may be obtained. In addition, according to this embodiment, the flatness of the surface of the film may be improved more effectively.

Although not specifically described in the above-described embodiment, the execution time of Step A may be longer than the execution time of Step B. Alternatively, the execution time of Step A may be shorter than the execution time of Step B. In either case, the same effects as those of the above-described embodiment may be obtained.

In the above-described embodiment, the case where the wafer 200 having a predetermined seed film formed on the surface thereof is used has been described. However, the present disclosure is not limited to such an embodiment. For example, the wafer 200 having no predetermined seed film formed on the surface thereof may be used. In this case, it is preferable to perform a step of forming a predetermined seed film on the surface of the wafer 200 before starting Step A. In this embodiment as well, the same effects as those of the above-described embodiment may be obtained.

In the above-described embodiment, the case where the first gas and the second gas are supplied in Step A has been described. However, the present disclosure is not limited to this embodiment. For example, the second gas may not be supplied in Step A. In this embodiment as well, the same effects as those of the above-described embodiment may be obtained.

Recipes used in each process may be prepared individually according to the processing contents and may be stored in the memory 121c via a telecommunication line or the external memory 123. Moreover, at the beginning of each process, the CPU 121a may properly select an appropriate recipe from the recipes recorded and stored in the memory 121c according to the processing contents. Thus, it is possible for a single substrate processing apparatus to form films of various kinds, composition ratios, qualities, and thicknesses with enhanced reproducibility. Further, it is possible to reduce an operator's burden and to quickly start each process while avoiding an operation error.

The recipes mentioned above are not limited to newly-prepared ones but may be prepared, for example, by modifying existing recipes that are already installed in the substrate processing apparatus. Once the recipes are modified, the modified recipes may be installed in the substrate processing apparatus via a telecommunication line or a recording medium storing the recipes. In addition, the existing recipes already installed in the existing substrate processing apparatus may be directly modified by operating the input/output device 122 of the substrate processing apparatus.

An example in which a film is formed using a batch-type substrate processing apparatus capable of processing a plurality of substrates at a time has been described in the above-described embodiments. The present disclosure is not limited to the above-described embodiments, but may be suitably applied, for example, to a case where a film is formed using a single-wafer type substrate processing apparatus capable of processing a single substrate or several substrates at a time. In addition, an example in which a film is formed using a substrate processing apparatus provided with a hot-wall-type process furnace has been described in the above-described embodiments. The present disclosure is not limited to the above-described embodiments, but may be suitably applied to a case where a film is formed using a substrate processing apparatus provided with a cold-wall-type process furnace.

In the above-described embodiment, the example in which the above-mentioned processing sequence is performed (*in-situ*) in the same process chamber of the same processing apparatus has been described. The present disclosure is not limited to the above-described embodiment. For example, one step and another step of the above-described processing sequence may be performed (*ex-situ*) in different process chambers of different processing apparatuses, or may be performed in different process chambers of the same processing apparatus.

Even in the case of using these substrate processing apparatuses, each process may be performed according to the same processing procedures and process conditions as those in the above-described embodiments and modifications, and the same effects as those of the above-described embodiments and modifications may be obtained.

The above-described embodiment and modifications may be used in combination as appropriate. Processing procedures and processing conditions at this time may be, for example, the same as the processing procedures and processing conditions of the above-described embodiment and modifications.

According to the present disclosure in some embodiments, it is possible to enhance a flatness of a surface of a film formed on a substrate and improve a surface roughness of the film.

While certain embodiments have been described, these embodiments have been presented by way of example only, and are not intended to limit the scope of the disclosures. Indeed, the embodiments described herein may be embodied in a variety of other forms. Further, various omissions, substitutions and changes in the form of the embodiments described herein may be made without departing from the disclosures. The accompanying claims and their equivalents are intended to cover such forms or modifications as would fall within the scope of the disclosures.

**Claims**

1. A substrate processing method, comprising:

    (a) supplying a first gas and a second gas to a substrate (200) to form a film; and
    (b) improving a flatness of a surface of the film.

2. The substrate processing method of Claim 1, wherein (a) is performed under conditions in which the first gas and the second gas are thermally decomposed.

3. The substrate processing method of Claim 1 or 2, wherein in (a), the first gas and the second gas are supplied so that a supply period of the first gas and a supply period of the second gas overlap at least partially with each other.

4. The substrate processing method of Claim 2, wherein in (a), at least a part of a molecular structure of molecules constituting the first gas and at least a part of a molecular structure of molecules constituting the second gas are adsorbed on the surface of the film.

5. The substrate processing method of Claim 4, wherein in (b), from among molecules physically adsorbed on the surface of the film and molecules chemically adsorbed on the surface of the film, at least the molecules physically adsorbed on the surface of the film are removed, or a part of the molecules chemically adsorbed on the surface of the film is removed.

6. The substrate processing method of any one of Claims 1 to 5, wherein in (b), an inert gas is supplied to the film.

7. The substrate processing method of Claim 6, wherein (b) includes (b1) removing a gas from a space in which the substrate (200) is present, and subsequently, (b2) supplying the inert gas.

8. The substrate processing method of Claim 7, wherein in (b), a cycle including (b1) and (b2) is performed a predetermined number of times.

9. The substrate processing method of Claim 7, wherein in (b), an opening degree of a valve for exhausting the space when (b2) is being executed is made smaller than an opening degree of the valve before (b2) is executed.

10. The substrate processing method of any one of Claims 1 to 9, wherein in (b), the number of atoms constituting the film is reduced.

11. The substrate processing method of Claim 4, wherein in (b), the number of at least one of molecules or atoms adsorbed on the surface of the film is reduced.

12. The substrate processing method of any one of Claims 1 to 11, wherein a cycle of performing (a) and (b) asynchronously is performed a predetermined number of times, and processing conditions in (b) are changed according to a first thickness of the film formed per cycle.

13. A method of manufacturing a semiconductor device comprising the substrate processing method of any one of Claims 1 to 12.

14. A program that causes, by a computer, a substrate processing apparatus to a process, the process comprising:

   (a) supplying a first gas and a second gas to a substrate (200) to form a film; and
   (b) improving a flatness of a surface of the film.

15. A substrate processing apparatus, comprising:

   a first gas supply system configured to supply a first gas to a substrate (200);
   a second gas supply system configured to supply a second gas to the substrate (200); and
   a controller (121) configured to be capable of controlling the first gas supply system and the second gas supply system so as to perform (a) supplying the first gas and the second gas to the substrate (200) to form a film, and (b) improving a flatness of a surface of the film.

# FIG. 1

# FIG. 2

# FIG. 3

FIG. 4

EP 4 527 976 A2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023156504 A